(19) Europäisches Patentamt
European Patent Office
Office européen des brevets

(11) EP 3 217 421 A1

(12) EUROPÄISCHE PATENTANMELDUNG

(43) Veröffentlichungstag:
13.09.2017 Patentblatt 2017/37

(51) Int Cl.:
H01L 21/20 (2006.01)       C23C 14/48 (2006.01)
H01L 21/762 (2006.01)

(21) Anmeldenummer: 17164931.2

(22) Anmeldetag: 24.06.2014

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR

(62) Dokumentnummer(n) der früheren Anmeldung(en)
nach Art. 76 EPÜ:
14732219.2 / 3 161 855

(71) Anmelder: EV Group E. Thallner GmbH
4782 St. Florian am Inn (AT)

(72) Erfinder: WIMPLINGER, Markus
4910 Ried im Innkreis (AT)

(74) Vertreter: Schneider, Sascha et al
Becker & Müller
Patentanwälte
Turmstraße 22
40878 Ratingen (DE)

Bemerkungen:
Diese Anmeldung ist am 05-04-2017 als
Teilanmeldung zu der unter INID-Code 62 erwähnten
Anmeldung eingereicht worden.

(54) **VORRICHTUNG ZUR OBERFLÄCHENBEHANDLUNG VON SUBSTRATEN**

(57) Die vorliegende Erfindung betrifft eine Vorrichtung zur Oberflächenbehandlung einer Substratoberfläche (1o) eines Substrats (1) mit:
- einer Prozesskammer zur Aufnahme des Substrats (1) und
- Mitteln zur Amorphisierung der Substratoberfläche (1o) unter Bildung einer amorphen Schicht (2, 2', 2") an der Substratoberfläche (1o) mit einer Dicke d > 0nm der amorphen Schicht (2, 2', 2").

Fig. 2

**EP 3 217 421 A1**

**Beschreibung**

Die vorliegende Erfindung betrifft eine Vorrichtung und eine Anlage gemäß den nebengeordneten Patentansprüchen.

In der Halbleiterindustrie werden bereits seit mehreren Jahren unterschiedliche Bondtechnologien verwendet um Substrate miteinander zu verbinden. Den Verbindungsvorgang nennt man Bonden. Man unterscheidet grob zwischen den Temporärbondverfahren und den Permanentbondverfahren.

Bei den Temporärbondverfahren wird ein Produktsubstrat mit einem Trägersubstrat so verbondet, dass es nach einer Prozessierung wieder gelöst werden kann. Mit Hilfe der Temporärbondverfahren ist es möglich, ein Produktsubstrat mechanisch zu stabilisieren. Die mechanische Stabilisierung garantiert, dass sich das Produktsubstrat handhaben lässt, ohne sich zu wölben, zu verformen oder zu brechen. Stabilisierungen durch Trägersubstrate sind vor allem während und nach einem Rückdünnprozess notwendig. Ein Rückdünnprozess erlaubt die Reduzierung der Produktsubstratdicke auf wenige Mikrometer.

Bei den Permanentbondverfahren werden zwei Substrate dauerhaft, d.h. permanent, miteinander verbondet. Das permanente Verbonden zweier Substrate erlaubt auch die Herstellung von mehrlagigen Strukturen. Diese mehrlagigen Strukturen können aus demselben oder aus unterschiedlichen Materialien bestehen. Es existieren unterschiedliche Permanentbondverfahren.

Das Permanentbondverfahren des anodischen Bondens wird verwendet, um ionenhaltige Substrate permanent miteinander zu verbinden. In den meisten Fällen handelt es sich bei einem der beiden Substrate um ein Glassubstrat. Das zweite Substrat ist vorzugsweise ein Siliziumsubstrat. In dem Verfahren wird ein elektrisches Feld entlang der beiden miteinander zu verbondenden Substrate angelegt. Das elektrische Feld wird zwischen zwei Elektroden, die vorzugsweise die beiden Oberflächen der Substrate kontaktieren, erzeugt. Das elektrische Feld erzeugt einen Ionentransport im Glassubstrat und bildet eine Raumladungszone zwischen den beiden Substraten aus. Die Raumladungszone bewirkt eine starke Anziehung der Oberflächen beider Substrate, die nach der Annäherung miteinander kontaktieren und damit eine bleibende Verbindung ausbilden. Der Bondvorgang beruht also vorwiegend auf der Maximierung der Kontaktfläche beider Oberflächen.

Ein weiteres Permanentbondverfahren ist das eutektische Bonden. Beim eutektischen Bonden wird eine Legierung mit einer eutektischen Konzentration erzeugt oder während des Bonden eingestellt. Durch das Überschreiten der eutektischen Temperatur, der Temperatur bei der sich die flüssige Phase mit den festen Phasen des Eutektikums im Gleichgewicht befindet, schmilzt das Eutektikum vollständig auf. Die erzeugte flüssige Phase der eutektischen Konzentration benetzt die Oberfläche der noch nicht verflüssigten Bereiche. Beim Erstarrungsvorgang erstarrt die flüssige Phase zum Eutektikum und bildet die Verbindungsschicht zwischen den beiden Substraten.

Ein weiteres Permanentbonderfahren ist das Fusionsbonden. Beim Fusionsbonden werden zwei ebene, reine Substratoberflächen durch Kontaktierung miteinander verbondet. Der Bondvorgang teilt sich dabei in zwei Schritte. In einem ersten Schritt erfolgt eine Kontaktierung der beiden Substrate. Die Fixierung der beiden Substrate erfolgt dabei vorwiegend durch van-der-Waals Kräfte. Die Fixierung bezeichnet man als Vorbond (engl.: prebond). Diese Kräfte erlauben die Herstellung einer Fixierung, die stark genug ist, um die Substrate so fest miteinander zu verbonden, dass eine gegenseitige Verschiebung, insbesondere durch das Aufbringen einer Scherkraft, nur mehr mit erheblichem Kraftaufwand möglich ist. Andererseits können die beiden Substrate, insbesondere durch Anlegen einer Normalkraft, wieder relativ leicht voneinander getrennt werden. Die Normalkräfte greifen dabei vorzugsweise am Rand an, um eine Keilwirkung in der Grenzfläche beider Substrate zu bewirken, welche einen fortlaufenden Riss erzeugt und somit beide Substrate wieder voneinander trennt. Um einen permanenten Fusionsbond zu erzeugen, werden die Substratstapel einer Wärmebehandlung unterzogen. Die Wärmebehandlung führt zur Ausbildung kovalenter Verbindungen zwischen den Oberflächen der beiden Substrate. Ein derartiger erzeugter Permanentbond ist nur mehr durch die Aufwendung einer entsprechend hohen, in den meisten Fällen mit einer Zerstörung der Substrate einhergehenden, Kraft möglich.

Die Druckschrift US5441776 beschreibt ein Verfahren zum Bonden einer ersten Elektrode zu einer hydrogenierten, amorphen Siliziumschicht. Diese amorphe Siliziumschicht wird durch Abscheideprozesse an der Oberfläche eines Substrats abgeschieden.

Die Druckschrift US7462552B2 zeigt ein Verfahren auf, bei dem eine chemische Gasphasenabscheidung (engl.: chemical vapour deposition, CVD) verwendet wird, um eine amorphe Siliziumschicht an der Oberfläche eines Substrats abzuscheiden. Die amorphe Schicht besitzt eine Dicke zwischen 0.5 und 10$\mu$m.

Suga et al. berichten in Ihrer Druckschrift US7550366B2 von einer unbeabsichtigt erzeugten amorphen Schicht, die ca. 100nm dick ist. Diese amorphe Schicht befindet sich zwischen den beiden Substratoberflächen, die durch einen Oberflächenaktivierungsprozess vorbereitet wurden. Die amorphe Schicht ist ein Nebenprodukt des Ionenbeschusses der Substratoberfläche mit Inertgas- und Metallatomen. Der eigentliche Bondvorgang findet somit zwischen Eisenatomen statt, die die amorphe Schicht bedecken.

Ein weiteres technisches Problem stellt die Wärmebehandlung dar. Die verbondeten Substrate sind sehr oft bereits mit funktionalen Einheiten wie beispielsweise Mikrochips, MEMs, Sensoren, LEDs versehen worden, die eine Temperaturempfindlichkeit besitzen. Insbesondere Mikrochips besitzen eine relativ starke Dotierung. Die Dotierelemente besitzen bei erhöhten Temperaturen eine erhöhte Diffusionsfähigkeit, die zu einer ungewollten, nachteiligen Verteilung der Dotierungen im Substrat führen kann. Des Weiteren sind Wärmebehandlungen immer mit erhöhten Temperaturen und damit auch mit höheren Kosten, mit der Erzeugung von thermischen Spannungen, und mit längeren Prozesszeiten für das Aufheizen und Abkühlen verbunden. Des Weiteren soll bei möglichst niedrigen Temperaturen gebondet werden, um eine Verschiebung unterschiedlicher Substratbereiche, die aus unterschiedlichen Materialien und damit im Allgemeinen auch aus unterschiedlichen thermischen Ausdehnungskoeffizienten bestehen, zu verhindern.

Eine Plasmabehandlung zur Reinigung und Aktivierung einer Substratoberfläche wäre eine Möglichkeit, bei relativ geringen Temperaturen zu Bonden. Derartige Plasmaverfahren funktionieren allerdings nicht oder nur sehr schlecht bei sauerstoffaffinen Oberflächen, insbesondere bei Metalloberflächen. Die sauerstoffaffinen Metalle oxidieren und bilden im Allgemeinen relativ stabile Oxide. Die Oxide sind wiederum hinderlich für den Bondvorgang. Derartige Metalle können auch relativ schwer durch Diffusionsbonds miteinander verbondet werden. Sehr gut hingegen funktioniert die Verbindung von Plasma aktiviertem, insbesondere monokristallinem, Silizium, welches eine Siliziumdioxidschicht ausbildet. Die Siliziumdioxidschicht eignet sich hervorragend zum Verbonden. Die genannten negativen Auswirkungen der Oxide beziehen sich daher nicht notwendigerweise auf alle Materialklassen.

In der Literatur existieren mehrere Ansätze, die das Direktbonden bei niedrigerer Temperatur beschrieben. Ein Ansatz in der PCT/EP2013/064239 besteht im Aufbringen einer Opferschicht, die während und/oder nach dem Bondprozess im Substratmaterial gelöst wird. Ein weiterer Ansatz in der PCT/EP2011/064874 beschreibt die Herstellung einer permanenten Verbindung durch Phasenumwandlungen. Die genannten Druckschriften beziehen sich insbesondere auf metallische Oberflächen, die eher über eine Metallbindung und nicht über kovalente Bindungen gebondet werden. In der PCT/EP2014/056545 wird ein optimierter Direktbondvorgang von Silizium durch eine Oberflächenreinigung beschrieben.

Ein weiteres Problem stellt die Oberflächenrauhigkeit der zu bondenden Oberflächen/Kontaktflächen dar. Insbesondere bei der Entfernung von Oxiden und Verunreinigungen von den Oberflächen der miteinander zu verbondenden Substrate mit bekannten Verfahren wird häufig eine höhere Rauhigkeit erzeugt. Diese Rauheit verhindert im mikroskopischen Maßstab eine vollständige Berührung der beiden Oberflächen während des Bondprozesses, was sich nachteilig auf die effektive Bondstärke auswirkt. Die beiden Substratoberflächen bonden praktisch überwiegend an sich berührenden Oberflächenmaxima. Es besteht daher insbesondere ein Gegensatz zwischen einer guten Reinigung und der Schaffung einer möglichst idealen Oberfläche.

In der Halbleiterindustrie sollen insbesondere sortengleiche Werkstoffe bzw. Materialien miteinander verbunden werden. Die Sortengleichheit sorgt dafür, dass über die Verbindungsstelle gleiche physikalische und chemische Eigenschaften vorhanden sind. Das ist insbesondere wichtig für Verbindungen, über die elektrischer Storm geleitet werden soll, die geringe

Korrosionsneigung und/oder gleiche mechanische Eigenschaften aufweisen sollen. Unter diesen sortengleichen Werkstoffen befinden sich vor allem:

- Kupfer-Kupfer
- Aluminium-Aluminium
- Wolfram-Wolfram
- Silizium-Silizium
- Siliziumoxid-Siliziumoxid

Einige der in der Halbleiterindustrie verwendeten Metalle sind sauerstoffaffin. So bildet Aluminium unter einer sauerstoffhaltigen Atmosphäre ein relativ festes Aluminiumoxid. Derartige Oxide wirken sich beim Bonden negativ auf das Bondergebnis aus, da sie zwischen den beiden miteinander zu verbondenen Materialien eingeschlossen werden. Unter extremen Bedingungen kann ein derartiges Oxid einen Bondvorgang gänzlich verhindern, unter optimalsten Bedingungen wird das Oxid eingeschlossen. Denkbar ist auch ein mechanisches Brechen der Oxidschicht vor der Einbettung. Das Oxid ist thermodynamisch stabil genug, um sich nicht zu zersetzen oder in feste Lösung zu gehen. Es verbleibt als Oxid in der Bondgrenzfläche und wirkt sich dort negativ auf die mechanischen Eigenschaften aus. Für Wolfram- und/oder Kupferbonds ergeben sich analoge Probleme.

Aufgabe der vorliegenden Erfindung ist es daher, eine Vorrichtung und eine Anlage anzugeben, mit welchen eine optimale Verbindung bei möglichst geringer Temperatur, insbesondere mit größtmöglicher Reinheit an der Bondgrenzfläche, erreicht wird.

Diese Aufgabe wird mit den Merkmalen der nebengeordneten Patentansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Grundidee der vorliegenden Erfindung ist es, eine, insbesondere überwiegend, amorphisierte Schicht mit einer definierten Dicke d an einer zu bondenden Substratoberfläche zu erzeugen. Die amorphisierte Schicht kann dabei insbesondere durch chemische und/oder physikalische Abscheideprozesse, vorzugsweise Sputtern, auf dem Substrat aufgebracht oder direkt aus dem Substrat erzeugt werden. Ein Hauptaspekt der Erfindung besteht allerdings darin, dass die amorphisierte Schicht nicht durch ein, mittels physikalischer und/oder chemischer Prozesse aufgebrachtes, Material, sondern durch eine Phasenumwandlung des Substratmaterials erfolgt. Dadurch kann auf die Abscheidung eines, insbesondere ungewollten oder schädlichen, Materials vollständig verzichtet werden. Im weiteren Verlauf wird daher vorwiegend auf die zweite Methode eingegangen.

Die Erfindung betrifft insbesondere eine Methode zum permanenten Bonden zweier Substrate, wovon wenigstens eines, vorzugsweise beide wie nachfolgend beschrieben vor dem Bonden behandelt wurde. Oberflächenbereiche, insbesondere eine Kontaktseite (vorzugsweise vollflächig) der beiden oder wenigstens eines der beiden Substrate werden vor dem Bondvorgang amorphisiert. Im weiteren Verlauf der Patentschrift wird die gesamte Substratoberfläche als amorphisierter Oberflächenbereich beschrieben, obwohl erfindungsgemäß auch die Amorphisierung von, insbesondere voneinander getrennter, Oberflächenbereiche, die kleiner sind als die Substrat Oberfläche, denkbar ist. Durch die Amorphisierung wird eine nanometerdicke Schicht erzeugt, in der die Atome mindestens einer der zu verbondenden Oberflächen (Kontaktseiten) regellos angeordnet werden. Diese regellose Anordnung führt zu einem besseren Bondergebnis, insbesondere bei vergleichsweise geringen Temperaturen. Zur Erzeugung eines erfindungsgemäßen Bonds wird insbesondere eine Reinigung der Oberflächen (zumindest der Kontaktseiten), insbesondere zur Befreiung von Oxiden, durchgeführt. Vorzugsweise erfolgt Reinigung und Amorphisierung gleichzeitig, noch bevorzugter durch dieselbe Behandlung. Ein wesentlicher erfindungsgemäßer Aspekt der Erfindung ist insbesondere die Verwendung niederenergetischer Teilchen, insbesondere Ionen, deren Energie vergleichsweise niedrig ist, allerdings ausreicht, um die erfindungsgemäß beschriebene Amorphisierung zu bewirken.

Die Entfernung des Oxids von den Substratoberflächen ist für einen optimalen Bondprozess und einen Substratstapel mit entsprechend hoher Bondstärke vorteilhaft. Dies gilt insbesondere für alle Materialien, bei denen eine sauerstoffhaltige Atmosphäre ein ungewolltes, natives Oxid bildet. Dies gilt nicht notwendigerweise für bewusst erzeugte Sauerstoffsubstratoberflächen wie beispielsweise für Siliziumoxid. Insbesondere werden erfindungsgemäß, vorzugsweise zumindest überwiegend, noch bevorzugter ausschließlich, schädliche, unnötige und/oder native, insbesondere metallische, Oxide entfernt. Vorzugsweise werden die vorgenannten Oxide vor einem Bondvorgang weitestgehend, insbesondere vollständig, entfernt, um nicht in die Bondgrenzfläche (Kontaktfläche zweier Substrate) eingebaut zu werden. Ein Einbau derartiger Oxide würde zu einer mechanischen Destabilisierung und zu einer sehr geringen Bondstärke führen. Die Entfernung des Oxids erfolgt durch physikalische oder chemische Verfahren. In einer besonders bevorzugten erfindungsgemäßen Ausführungsform erfolgt die Entfernung der ungewollten Oxide mit derselben Anlage, mit deren Hilfe das erfindungsgemäße Verfahren ausgeführt wird. Dadurch können, insbesondere unter optimalen Umständen:

- Oxidentfernung
- Oberflächenglättung
- Amorphisierung

gleichzeitig durchgeführt werden. In alternativen erfindungsgemäßen Ausführungsformen erfolgt die Oxidentfernung nicht in derselben Anlage.

Dabei muss insbesondere sichergestellt werden, dass es zu keiner erneuten Oxidation der Substratoberflächen beim Transfer der Substrate zwischen den beiden Anlagen kommt.

Der erfindungsgemäße Gedanke besteht mit anderen Worten insbesondere in der Erhöhung der Bondfestigkeit zwischen zwei Substratoberflächen durch Amorphisierung. Die Amorphisierung löst dabei mehrere Probleme:

Erstens geht der erfindungsgemäßen Amorphisierung vorzugsweise eine Reinigung der Substratoberfläche voran. Insbesondere werden Reinigung der Substratoberfläche und Amorphisierung gleichzeitig, noch bevorzugter durch den gleichen Prozess, durchgeführt.

Zweitens bewirkt die erfindungsgemäßen Amorphisierung eine Planarisierung der Substratoberfläche. Die Planarisierung findet dabei während der Amorphisierung, insbesondere zusätzlich durch die während des Bondvorgangs wirkende Krafteinwirkung, statt.

Drittens wird durch die Amorphisierung ein thermodynamisch metastabiler Zustand an der Substratoberfläche (Bondgrenzfläche) erzeugt. Dieser metastabile Zustand führt in einem weiteren Prozessschritt (insbesondere nach Kontaktierung der zu bondenden Oberflächen) eine (Rück-)Umwandlung von Teilbereichen der amorphen Schicht in einen kristallinen Zustand. Im Idealfall erfolgt eine vollständige Umwandlung der amorphen Schicht. Die resultierende Schichtdicke nach der Kontaktierung und der anschließenden Wärmebehandlung der amorphen Schicht ist insbesondere größer als null.

Ein erfindungsgemäßer Gedanke besteht vor allem in der Erzeugung der amorphen Schicht aus dem vorhandenen Grundmaterial des Substrats, insbesondere durch Teilchenbeschuss. Vorzugsweise wird vor dem Bonden der Substrate kein Material auf die zu kontaktierenden Substratoberflächen aufgebracht.

Das erfindungsgemäße Verfahren erlaubt die Herstellung eines vollständigen und/oder vollflächigen, insbesondere sortenreinen, Kontakts zweier Substratoberflächen, wovon mindestens eine, vorzugsweise beide, erfindungsgemäß amorphisiert sind. Durch die vollständige Kontaktierung werden Verunreinigungen, Einschlüsse, Leerräume und Lunker vollständig vermieden.

Das erfindungsgemäße Verfahren wird insbesondere für die Herstellung eines vollständigen und/oder vollflächigen und/oder nicht sortenreinen Kontakt zweier, vorzugsweise unterschiedlicher, Substratoberflächen verwendet. Insbesondere können folgende Materialien in beliebiger Kombination miteinander verbondet werden.

- Metalle, insbesondere,

  ○ Cu, Ag, Au, Al, Fe, Ni, Co, Pt, W, Cr, Pb, Ti, Te, Sn, Zn

- Legierungen
- Halbleiter (mit entsprechender Dotierung), insbesondere

  ○ Elementhalbleiter, insbesondere

    ▪ Si, Ge, Se, Te, B, □-Sn

  ○ Verbindungshalbleiter, insbesondere

    ▪ GaAs, GaN, InP, InxGa1-xN,InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGa1-xAs, GaS, GaSe, GaTe, InS, InSe, InTe, CuInSe2, CuInS2, CuInGaS2, SiC, SiGe

- Organische Halbleiter, insbesondere

  ○ Flavanthron, Perinon, Alq3, Perinon, Tetracen, Chinacridon, Pentacen, Phthalocyanine, Polythiophene, PTCDA, MePTCDI, Acridon, Indanthron

Bevorzugt werden erfindungsgemäß folgende Materialkombinationen verwendet:

- GaN - Cu,
- GaAs - SiO2,
- Cu - Al.

Obwohl die erfindungsgemäße Ausführungsform vor allem zum Verbinden zweier Substratoberflächen aus unterschiedlichen Materialien geeignet ist, wird im weiteren Verlauf des Patents der Einfachheit halber vorwiegend auf die Verbindung zweier sortengleicher Substratoberflächen Bezug genommen. Die Erfindung betrifft mit anderen Worten insbesondere eine Methode zum Direktbonden. Der Erfindung liegt dabei bevorzugt der Gedanke zugrunde, mindestens eine (insbesondere an der Kontaktseite angeordnete) Oberfläche eines Substrats vor dem Bondvorgang zu amorphisieren. Die Amorphisierung erfolgt bevorzugt nicht durch das Abscheiden eines Materials, das unter den gegebenen Abscheideparametern an der Substratoberfläche amorph resublimiert bzw. kondensiert, sondern insbesondere durch eine Änderung, Urformung und/oder Phasenumwandlung einer amorphen Schicht an der Substratoberfläche. Dies erfolgt insbesondere durch die Einbringung kinetischer Energie durch Teilchenbeschuss, insbesondere Ionenbeschuss, am bevorzugtesten durch einen niederenergetischen Ionenbeschuss.

**Amorphisierung**

Unter der Amorphisierung wird die regellose Anordnung der Atome im Gegensatz zur wohldefinierten Anordnung von Atomen in einem Kristall verstanden. Bei den Atomen kann es sich um die Atome eines einatomaren Einkomponentensystems, eines mehratomaren Einkomponentensystems, eines einatomaren Mehrkomponentensystems oder eines mehratomaren Mehrkomponentensystems handeln. Unter Komponente versteht man einen unabhängig veränderbaren stofflichen Bestandteil einer Phase. Die amorphe Phase besitzt insbesondere keine Nah- und/oder keine Fernordnung. Unter einem zumindest teilweise amorphen Gefüge der erfindungsgemäß ausgebildeten amorphen Schicht wird ein Phasengemenge verstanden, das zumindest aus einer amorphen Phase und einer kristallinen Phase besteht. Das Volumenverhältnis zwischen der amorphen Phase und dem Gesamtvolumen soll als Amorphisierungsgrad bezeichnet werden. Erfindungsgemäß ist der Amorphisierungsgrad insbesondere größer als 10%, vorzugsweise größer als 25%, noch bevorzugter größer al 50%, am bevorzugtesten größer als 75%, am allerbevorzugtesten größer als 99%.

Die erfindungsgemäße Amorphisierung wird insbesondere auf den oberflächennahen Bereich der miteinander zu verbondenden Substrate beschränkt, vorzugsweise durch Wahl der Prozessparameter Temperatur, Druck, Ionenenergie und/oder Ionenstromdichte während der Amorphisierung. Insbesondere bleibt das Material des Substrats dabei abgesehen von der erfindungsgemäß amorphisierten Schicht zumindest überwiegend, vorzugsweise vollständig, kristallin.

In einer ersten erfindungsgemäßen Ausführungsform wird nur die Substratoberfläche eines ersten Substrats amorphisiert. Die Dicke d der amorphen Schicht unmittelbar nach der erfindungsgemäßen Erzeugung in einer Substratoberfläche ist insbesondere kleiner als 100nm, vorzugsweise kleiner als 50nm, noch bevorzugter kleiner als 10nm, am bevorzugtesten kleiner als 5nm, am allerbevorzugtesten kleiner als 2nm.

Gemäß einer erfindungsgemäßen Weiterbildung wird die Substratoberfläche eines ersten Substrats und die Substratoberfläche eines zweiten Substrats amorphisiert. In einer besonderen erfindungsgemäßen Ausführungsform erfolgt die Amorphisierung beider Substratoberflächen in der gleichen Anlage, insbesondere gleichzeitig, um unter gleichen Prozessparametern gleiche amorphe Schichten zu erzeugen. Die erzeugten amorphen Schichten besitzen vorzugsweise die gleiche Dicke $d_1$ der ersten amorphen Schicht des ersten Substrats und $d_2$ der zweiten amorphen Schicht des zweiten Substrats.

Das Verhältnis der Dicken $d_1/d_2$ der beiden, insbesondere gleichzeitig erzeugten, amorphen Schichten ist $0.6<d_1/d_2<1.4$, vorzugsweise $0.7<d_1/d_2<1.3$, noch bevorzugter $0.8<d_1/d_2<1.2$, am bevorzugtesten $0.9<d_1/d_2<1.1$, am allerbevorzugtesten $0.99<d_1/d_2<1.01$.

Die Substratoberflächen besitzen vor, während und nach der Amorphisierung eine geringe, aber insbesondere nicht vernachlässigbare, Rauheit. In einer bevorzugten Ausführungsform wird die Rauheit der Substratoberfläche während der Amorphisierung reduziert und besitzt nach der Amorphisierung ein Minimum. Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Eine Messung der Oberflächenrauheit erfolgt mit einem der (dem Fachmann bekannten) Messgeräte, insbesondere mit einem Profilometer und/oder einem Rasterkraftmikroskop (engl.: atomic force microscope, AFM). Die Messfläche beträgt dabei insbesondere $200\mu m$ x $200\mu m$. Daher sind die folgenden Zahlenwertebereiche für die Rauheit entweder als Werte für die mittlere Rauheit, die quadratische Rauheit oder für die gemittelte Rauhtiefe zu verstehen. Die Rauheit der Substratoberfläche vor der Amorphisierung ist erfindungsgemäß insbesondere kleiner als 10nm, vorzugsweise kleiner als 8nm, noch bevorzugter kleiner als 6nm, am bevorzugtesten kleiner als 4nm, am allerbevorzugtesten kleiner als 1nm. Die Rauheit der Substratoberfläche nach der Amorphisierung ist insbesondere kleiner als 10nm, vorzugsweise kleiner als 8nm, noch bevorzugter kleiner als 6nm, am bevorzugtesten kleiner als 4nm, am allerbevorzugtesten kleiner als 1nm.

Die Amorphisierung erfolgt vorzugsweise durch Teilchenkollision mit der Substratoberfläche. Bei den Teilchen handelt es sich entweder um geladene oder um nicht geladene Teilchen. Die Beschleunigung erfolgt bevorzugt mit geladenen Teilchen (Ionen), da geladene Teilchen technisch leichter beschleunigt werden können.

Die Ionen dienen erfindungsgemäß bevorzugt auch der Reinigung der Substratoberfläche. Erfindungsgemäß wird daher insbesondere eine Reinigung der Substratoberfläche, insbesondere eine Oxidentfernung, mit der Amorphisierung kombiniert. Soweit die Substrate, insbesondere unmittelbar, vor der Amorphisierung gereinigt worden sind, kann das erfindungsgemäße Verfahren allerdings auch ausschließlich zur Herstellung der amorphen Schicht verwendet werden. Das Verhältnis zwischen der gesamten Oberfläche F des Substrats und der gereinigten Oberfläche f wird als Reinheitsgrad r bezeichnet. Der Reinheitsgrad ist vor dem erfindungsgemäßen Bondvorgang insbesondere größer als 0, vorzugsweise größer als 0.001, noch bevorzugter größer als 0.01, am bevorzugtesten größer als 0.1, am allerbevorzugtesten 1.

$$r = f/F$$

Die Reinigung und/oder die Amorphisierung finden bevorzugt in einer Vakuumkammer als Prozesskammer statt. Die Vakuumkammer ist dabei auf weniger als 1bar, vorzugsweise weniger als 1mbar, noch bevorzugter weniger als $10^{-3}$mbar, am bevorzugtesten weniger als $10^{-5}$mbar, am allerbevorzugtesten weniger als $10^{-8}$mbar evakuierbar. Die Vakuumkammer wird, insbesondere vor der Verwendung der Ionen zur Amorphisierung, vorzugsweise auf einen vorgenannten Druck, noch bevorzugter vollständig, evakuiert. Insbesondere wird der Sauerstoffanteil in der Prozesskammer so stark reduziert, dass eine erneute Oxidation der Substratoberflächen nicht möglich ist.

Es werden erfindungsgemäß insbesondere folgende Gase und/oder Gasgemische für die Amorphisierung ionisiert:

- Atomare Gase, insbesondere

    ○ Ar, He, Ne, Kr,

- Molekulare Gase, insbesondere

    ○ $H_2$, $N_2$, CO, $CO_2$,

- Gasgemische, insbesondere

    - Formiergas FG ( Argon + Wasserstoff) und/oder
    - Formiergas RRG (Wasserstoff + Argon) und/oder
    - Formiergas NFG (Argon + Stickstoff) und/oder
    - Wasserstoff.

Die verwendeten Gasgemische haben insbesondere folgende Zusammensetzung

| Gasmischung FG | Ar (%) | H (%) | Gasmischung RFG | H(%) | Ar (%) | Gasmischung NFG | Ar (%) | N2 (%) |
|---|---|---|---|---|---|---|---|---|
| FG 0 | 100 | Atmosphäre (10 sccm) | RFG 0 | 100 | Atmosphäre (10 sccm) | NFG 0 | 100 | Atmosphäre (10 sccm) |
| FG 1 | 96 | 4 | RFG 1 | 100 | 0 | NFG 1 | 95 | 5 |
| FG 2 | 90 | 10 | RFG 2 | 95 | 5 | NFG 2 | 90 | 10 |
| FG 3 | 80 | 20 | RFG 3 | 90 | 10 | NFG 3 | 80 | 20 |
| FG 4 | 70 | 30 | RFG 4 | 70 | 30 | NFG 4 | 70 | 30 |
| FG 5 | 50 | 50 | RFG 5 | 50 | 50 | NFG 5 | 50 | 50 |
| Tabelle 1: Die Tabelle zeigt eine Auflistung von drei beispielhaften Gasmischungen, FGx, RFGx und NFGx mit ihren jeweiligen Anteilen an Argon und Wasserstoff, bzw. Argon und Stickstoff. | | | | | | | | |

Die Ionen werden in einem Ionisierungsprozess erzeugt. Der Ionisierungsprozess findet vorzugsweise in einer Ionenkammer statt. Die erzeugten Ionen verlassen die Ionenkammer und werden vorzugsweise durch ein elektrisches und/oder ein magnetisches Feld beschleunigt. Denkbar ist auch eine Ablenkung der Ionen durch elektrische und/oder magnetische Felder. Die Ionen treffen in einem Ionenstrahl auf de Substratoberfläche auf. Der Ionenstrahl zeichnet sich durch eine mittlere Ionendichte aus.

Gemäß einer Ausführungsform der Erfindung ist der Einfallswinkel zwischen der Substratoberfläche und dem Ionenstrahl frei wähl- und einstellbar. Der Einfallswinkel wird definiert als der Winkel zwischen der Substratoberfläche und dem Ionenstrahl. Der Einfallswinkel liegt insbesondere zwischen 0° und 90°, vorzugsweise zwischen 25° und 90°, noch bevorzugter zwischen 50° und 90°, am bevorzugtesten zwischen 75° und 90°, am allerbevorzugtesten bei exakt 90°. Durch den Einfallswinkel des Ionenstrahls kann die Einschlagenergie der Ionen auf der Substratoberfläche gesteuert werden. Durch die Einschlagenergie ist die Amorphisierung steuerbar. Des Weiteren kann durch den Einfallswinkel (und die damit verbundene Einschlagsenergie der Ionen auf der Substratoberfläche) die Abtragung von Verunreinigungen, insbesondere Oxiden, gesteuert werden. Des Weiteren erlaubt die exakte Wahl des Einfallswinkels die Steuerung der Abtragungsrate und damit der Oberflächenrauhigkeit. Der Einfallswinkel wird daher insbesondere so gewählt, dass Amorphisierung, Abtragung der Verunreinigungen, insbesondere der Oxide, und Oberflächenglättung für das gewünschte Ergebnis maximiert werden. Unter Maximierung versteht man insbesondere eine vollständige Entfernung der Verunreinigungen, insbesondere der Oxide, eine noch weitere, insbesondere vollständige, Glättung der Oberfläche (also eine Reduktion des Rauhigkeitswertes auf null) sowie eine optimale, insbesondere dicke, amorphisierte Schicht.

Die Steuerung der Amorphisierung erfolgt gemäß einer weiteren Ausführungsform der Erfindung durch Einstellung der kinetischen Energie der beschleunigten Teilchen, insbesondere Ionen. Die kinetische Energie der Teilchen wird insbesondere zwischen 1 eV und 1000 keV, vorzugsweis zwischen 1 eV und 100 keV, noch bevorzugter zwischen 1 eV und 10 keV, am bevorzugtesten zwischen 1 eV und 1 keV, am allerbevorzugtesten zwischen 1 eV und 200 eV, eingestellt.

Die Stromdichte (die Anzahl der Teilchen, insbesondere Ionen, pro Zeit- und Flächeneinheit) wird insbesondere zwischen 0.1 mA/cm$^2$ und 1000 mA/cm$^2$ vorzugsweise zwischen 1.0 mA/cm$^2$ und 500 mA/cm$^2$, noch bevorzugter zwischen 50 mA/cm$^2$ und 100 mA/cm$^2$, am bevorzugtesten zwischen 70 mA/cm$^2$ und 80 mA/cm$^2$, am allerbevorzugtesten 75 mA/cm$^2$, gewählt.

Die Behandlungsdauer wird insbesondere zwischen 1s und 200s, vorzugsweise zwischen 10s und 200s, noch bevorzugter zwischen 50s und 200s, am bevorzugtesten zwischen 100s und 200s, gewählt.

Bonden

Das Bonden erfolgt insbesondere in einer separaten Bondkammer, wobei die Bondkammer vorzugsweise in einer Cluster-Anlage integral an die Prozesskammer zur Amorphisierung angeschlossen ist, noch bevorzugter unter ständiger Aufrechterhaltung der Evakuierung von der Prozesskammer in die Bondkammer überführbar ist.

Nach der erfindungsgemäßen Amorphisierung mindestens einer der beiden Substratoberflächen erfolgt insbesondere eine Ausrichtung der beiden Substrate zueinander. Vorzugsweise erfolgt die Ausrichtung durch Ausrichtungsanlagen (engl.: aligner) und anhand von Ausrichtungsmarken.

Nach der Ausrichtung der beiden Substrate zueinander erfolgt insbesondere eine Kontaktierung. Die Kontaktierung wird vorzugsweise im Zentrum begonnen und radial nach außen bis zur vollständigen Kontaktierung fortgeführt. Bei dieser Kontaktierungsart wird eine Verdrängung von Gasen gewährleistet. Des Weiteren werden die beiden Substrate mit einer möglichst geringen Verzerrung zueinander kontaktiert.

Die Kontaktierung bewirkt vorzugsweise eine Vorfixierung, insbesondere einen Vorbond. Der Vorbond zeichnet sich durch eine Bindungsfestigkeit zwischen 0.01 J/m$^2$ und 2.5 J/m$^2$, bevorzugter zwischen 0.1 J/m$^2$ und 2 J/m$^2$, noch bevorzugter zwischen 0.5 J/m$^2$ und 1.5 J/m$^2$, am bevorzugtesten zwischen 0.8 J/m$^2$ und 1.2 J/m$^2$ aus. Der Vorbond führt nicht notwendigerweise zu einer vollständigen Kontaktierung der beiden Substratoberflächen.

In einem weiteren erfindungsgemäßen Schritt erfolgt der eigentliche Bondvorgang der vorgebondeten Substrate. Der eigentliche Bondvorgang besteht insbesondere aus einer Kraft und/oder Temperatureinwirkung. Die erfindungsmäße Bondtemperatur ist insbesondere kleiner als 200°C, vorzugsweise kleiner als 150°C, noch bevorzugter kleiner als 100 °C, am bevorzugtesten kleiner als 100°C, am allerbevorzugtesten kleiner als 50°C. Die erfindungsgemäße Bondkraft ist insbesondere größer als 0.01 kN, vorzugsweise größer als 0.1 kN, noch bevorzugter größer als 1 kN, am bevorzugtesten größer als 10 kN, am aller bevorzugtesten größer als 100 kN. Die entsprechenden Druckbereiche ergeben sich durch Normierung der erfindungsgemäßen Bondkraft auf die Fläche der Substrate. Die Substrate können eine beliebige Form besitzen. Insbesondere sind die Substrate kreisförmig und werden gemäß Industriestandard über den Durchmesser charakterisiert. Die Substrate können jede beliebige Form besitzen, sind aber bevorzugt kreisrund. Für Substrate, insbesondere die sogenannten Wafer, sind die industrieüblichen Durchmesser, 1 Zoll, 2 Zoll, 3 Zoll, 4 Zoll, 5 Zoll, 6 Zoll, 8 Zoll, 12 Zoll und 18 Zoll. Die erfindungsgemäße Ausführungsform kann aber grundsätzlich jedes Substrat, unabhängig von dessen Durchmesser handhaben.

Erfindungsgemäß führt die Druckbeanspruchung zu einer Annäherung der Substratoberflächen in der (entlang der Kontaktfläche der Substratoberflächen ausgebildeten) Grenzschicht an der durch den Vorbond noch keine Kontaktierung erfolgt. Die Annäherung der Substratoberflächen führt zu einer kontinuierlichen Verkleinerung und einem letztendlichen Verschluss von Kavitäten. Erfindungsgemäß spielt dabei die Amorphisierung eine entscheidende Rolle, da durch den amorphen Zustand eine oberflächenisotrope elektrostatische Anziehung erfolgt. Da die miteinander kontaktierenden, amorphen Schichten der Substratoberflächen beide nicht kristallin sind, muss auch nicht auf eine das Kristallgitter fortsetzende und angepasste Kontaktierung geachtet werden. Die Kontaktierung zweier Substratoberflächen mit amorphen Schichten führt damit zur Erzeugung einer neuen, größeren, amorphen Schicht. Der Übergang gestaltet sich fließend und ist erfindungsgemäß vor allem durch das vollständige Verschwinden einer Grenzschicht charakterisiert.

Die Dicke der gesamten, gebondeten amorphen Schicht, insbesondere unmittelbar, nach dem erfindungsgemäßen Bondvorgang ist insbesondere kleiner als 100nm, vorzugsweise kleiner als 50nm, noch bevorzugter kleiner als 10nm, am bevorzugtesten kleiner als 5nm, am allerbevorzugtesten kleiner als 2nm.

Die Bondstärke wird insbesondere durch drei maßgebliche Parameter beeinflusst, nämlich

- die Dicke der amorphen Schicht,
- die Rauhigkeit,
- die Anzahl der sich negativ auswirkenden, eingebauten Ionen und
- die Bondkraft.

Erfindungsgemäß nimmt die Bondstärke mit steigender Dicke der amorphen Schicht insbesondere zu. Je dicker die amorphe Schicht, desto größer die Anzahl der regellos angeordneten Atome. Die regellos angeordneten Atome unterliegen keinem Fern- und/oder Nahordnungsparameter und werden durch genannte Prozesse, insbesondere Diffusion und Annäherung durch Druckbeaufschlagung, die Kavitäten entsprechend leicht füllen, da sie sich nicht an ein geregeltes Gitter anpassen müssen. Durch die Füllung erhöhen sich die Kontaktoberfläche und damit die Bondstärke. Die Erhöhung der Kontaktfläche wird als maßgeblicher Parameter für die Bondstärke identifiziert. Ist die mittlere Dicke der amorphen Schicht kleiner als die mittlere Rauhigkeit, stehen nicht genügend Atome der amorphen Phase zur Verfügung, um die Kavitäten zu schließen. Andererseits muss erwähnt werden, dass eine Substratoberfläche mit einer sehr geringen Rauhigkeit auch über entsprechend kleine Kavitäten verfügt. Je geringer also die Rauhigkeit einer Substratoberfläche, desto geringer kann auch die Dicke der amorphen Schicht sein, um ein gewünschtes Bondergebnis zu erhalten. Eine entsprechend dicke amorphe Schicht wird erfindungsgemäß durch eine entsprechend hohe Ionenenergie erreicht, welche dazu führt, dass die Ionen möglichst tief in das Substrat eindringen können.

Die Auswirkungen der Rauhigkeit sind analog zu verstehen. Je größer die Rauhigkeit, desto schwerer gestaltet sich die Annäherung der Substratoberflächen und desto mehr Energie müssen die Atome der amorphen Substratoberflächen aufwenden, um die Kavitäten zu füllen und damit die Kontaktfläche zu maximieren.

Die Bondstärke ist auch eine Funktion der Reinheit der amorphen Schicht. Jedes eingelagerte Atom oder Ion kann insbesondere zur Destabilisierung, insbesondere Erniedrigung der Bondfestigkeit führen. Die der Amorphisierung dienenden Ionen können daher auch einen negativen Einfluss auf die Bondstärke haben, insbesondere wenn sie nach der Amorphisierung in der amorphen Schicht verbleiben. Daher wird neben einer entsprechend geringen Ionenenergie auch eine möglichst geringe Stromdichte und Behandlungsdauer angestrebt.

Multipliziert man die Stromstärke mit der Behandlungsdauer, erhält man die pro Einheitsflächenabschnitt innerhalb der Behandlungsdauer auf der Substratoberfläche aufgetroffenen Ionen. Um diese Anzahl zu minimieren, können die Stromdichte und/oder die Behandlungszeit reduziert werden. Je weniger Ionen pro Einheitsfläche auf der Substratoberfläche auftreffen, desto weniger Ionen werden in die amorphe Schicht eingebaut. Negative Auswirkungen auf die Bondstärke haben vor allem jene Teilchen, welche mit dem zu amorphisierenden Material keine Bindung eingehen können und nur als Defekte, insbesondere Punktdefekt, vorliegen. Dazu zählen vor allem die Edelgase, aber auch molekulare Gase.

Insbesondere ist erfindungsgemäß die Verwendung von Gasen bzw. Gasgemischen denkbar, deren Ionen für eine Verstärkung des Bondinterfaces, insbesondere durch Bildung neuer Phasen, verantwortlich sind. Eine bevorzugte Möglichkeit wäre die Verwendung von ionisiertem Stickstoff, der die amorphe Schicht nitriert.

Analoge Überlegungen gelten für alle anderen Arten von Elementen, welche eine Verbindung, insbesondere eine metallische, kovalente oder ionische Bindung mit dem Material der amorphen Schicht eingehen. Um die Stromdichte erniedrigen zu können, werden insbesondere Substratoberflächen bevorzugt, die bereits über eine minimale Rauhigkeit verfügen. Je glatter die Substratoberfläche, desto weniger und niederenergetischere Ionen werden erfindungsgemäß für die Reduktion der Rauhigkeit benötigt. Dadurch wird eine Reduktion,der Ionenenergie und/oder des Ionenstroms und damit der Anzahl der Ionen pro Einheitsfläche ermöglicht, was wiederum zu einer geringeren Anzahl eingebauter Ionen und in der Folge zu weniger Defekten und schließlich zu einer erhöhten Bondfestigkeit führt.

Die Bondstärke ist eine Funktion der Bondkraft, da eine höhere Bondkraft zu einer stärkeren Annäherung der Substratoberflächen und damit zu einer besseren Kontaktfläche führt. Je höher die Bondkraft, desto leichter werden Substratoberflächen aneinander angenähert und verschließen damit durch lokal verformte Bereiche die Kavitäten.

**Wärmebehandlung**

Eine, insbesondere von dem Amorphisierungsprozess getrennte, Wärmebehandlung erfolgt insbesondere entweder während und/oder nach dem Bonden in dem Bonder oder nach dem Bonden in einem externen (insbesondere in den Cluster integrierten) Wärmebehandlungsmodul. Bei dem Wärmebehandlungsmodul kann es sich um eine Heizplatte, einen Heizturm, einen Ofen, insbesondere einen Durchlaufofen oder jede andere Art von wärmeerzeugender Vorrichtung handeln.

Die Wärmebehandlung findet insbesondere bei Temperaturen kleiner 500°C, vorzugsweise kleiner 400°C, noch bevorzugter kleiner 300°C, am bevorzugtesten kleiner 200°C, am allerbevorzugtesten kleiner 100°C statt.

Die Zeitdauer der Wärmebehandlung wird insbesondere derart gewählt, dass die Dicke der erfindungsgemäßen, amorphen Restschicht nach der Wärmebehandlung kleiner als 50nm, vorzugsweise kleiner als 25nm, noch bevorzugter kleiner als 15nm, am bevorzugtesten kleiner als 10nm, am allerbevorzugtesten kleiner als 5nm, ist. Die Restschichtdicke wird insbesondere in den meisten untersuchten Fällen niemals vollständig verschwinden, da eine vollständige Umwandlung der amorphen Schicht nur mit einer vollständigen Anpassung der umgewandelten Kristallgitter der beiden Substratoberflächen möglich ist. Da eine vollständige Anpassung aus energetischen und geometrischen Gründen eher unwahrscheinlich ist, verbleibt in den meisten erfindungsgemäß beschriebenen Fällen eine von null verschieden Restschichtdicke.

Insbesondere erfolgt beim und/oder nach dem Bonden und/oder bei der Wärmebehandlung eine Phasenumwandlung vom amorphen Zustand in den kristallinen Zustand.

In einer ganz bevorzugten erfindungsgemäßen Ausführungsform werden die genannten Prozessparameter so gewählt, dass eine vollständige Umwandlung der amorphen Schicht in die kristalline Phase erfolgt.

Erfindungsgemäß wird gemäß einer vorteilhaften Ausführungsform die Reinheit des umwandelnden Materials in Massenprozent (m%) insbesondere größer als 95m%, vorzugsweise größer als 99m%, noch bevorzugter größer als 99,9m%, am bevorzugtesten größer als 99,99m%, am allerbevorzugtesten größer als 99,999m%, gewählt. Durch die große Reinheit des Substratmaterials wird ein noch besseres Bondergebnis erzielt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:

Figur 1    eine schematische, nicht maßstabsgetreue Querschnittsdarstellung einer Ausführungsform eines erfindungsgemäß behandelten Substrats in einem ersten Verfahrensschritt (Amorphisierung) einer Ausführungsform eines erfindungsgemäßen Verfahrens,

Figur 2    eine schematische, nicht maßstabsgetreue Querschnittsdarstellung eines zweiten Verfahrensschrittes (Kontaktieren/Vorbonden) einer Ausführungsform eines erfindungsgemäßen Verfahrens,

Figur 3    eine schematische, nicht maßstabsgetreue Querschnittsdarstellung eines dritten Verfahrensschrittes (Bonden),

Figur 4    eine schematische, nicht maßstabsgetreue Querschnittsdarstellung eines vierten Verfahrensschrittes (Wärmebehandlung) und

Figur 5    eine schematische, nicht maßstabsgetreue Querschnittsdarstellung einer Anlage/Vorrichtung zur Erzeugung einer amorphen Schicht.

In den Figuren sind gleiche oder gleichwirkende Merkmale mit den gleichen Bezugszeichen gekennzeichnet.

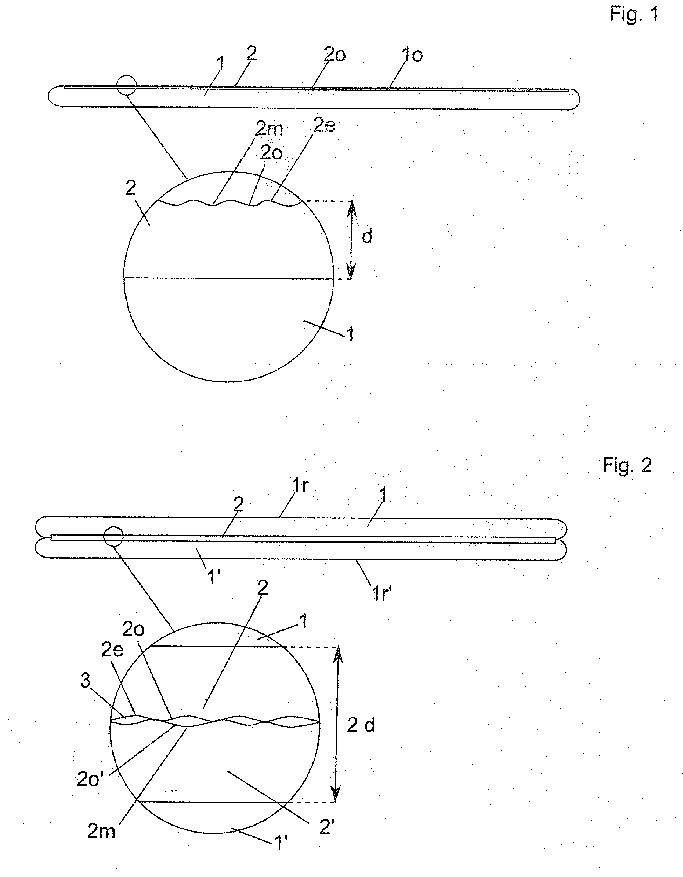

Die Figur 1 zeigt eine schematische, nicht maßstabsgetreue Querschnittsdarstellung eines ersten Substrats 1 mit einer an einer Substratoberfläche 1o erfindungsgemäß erzeugten, amorphen Schicht 2. Die amorphe Schicht 2 besitzt im Allgemeinen noch eine raue Oberfläche 2o. Die Rauhigkeit wird vorzugsweise während der Entfernung eines Oxids oder anderer Produkte auf ein Minimum reduziert. Die amorphe Schicht 2 erstreckt sich von der Substratoberfläche 1o über eine Tiefe (Dicke d) in das Substrat 1.

Die Figur 2 zeigt eine schematische, nicht maßstabsgetreue Querschnittsdarstellung eines Vorbonds zweier gemäß Figur 1 behandelter Substrate 1,1'. Der Vorbondprozess zeichnet sich durch eine Kontaktierung der Substratoberflächen 1o, 1o' (Kontaktflächen) entlang von Oberflächen 2o, 2o' der amorphen Schichten 2, 2' aus. Die Kontaktierung erfolgt dabei insbesondere an Maxima 2e der Oberflächen 2o, 2o'. Durch eine von Null verschiedene, aber insbesondere durch die Amorphisierung gemäß Figur 1 schon stark reduzierte, Rauhigkeit kommt es dabei zur Ausbildung von Kavitäten 3. In ganz besonders bevorzugten Fällen greifen möglichst viele Maxima 2e teilweise, insbesondere vollständig, in die Minima 2m ein, um die Anzahl der erzeugten Kavitäten 3 bzw. deren Volumen bereits während des Vorbondvorgangs zu minimieren.

Durch einen erfindungsgemäßen Bondprozess wird, insbesondere durch Kraftbeaufschlagung quer zu den Substratoberflächen 1o, 1o' an Rückseiten 1r, 1r' der Substrate 1, 1', die Kontaktierung der Oberflächen 2o, 2o' vervollständigt und die (summierten) Dicken d der aus den amorphen Schichten 2, 2' gebildeten gemeinsamen amorphen Schicht 2" werden auf eine (gemeinsame) Schichtdicke d' reduziert . Zu diesem Zeitpunkt kann bevorzugt zwischen den verbondeten Oberflächen 1o, 1o' der miteinander verbondeten Substrate 1, 1' nicht mehr unterschieden werden. Diese Eigenschaft wird auch als spezifisches Merkmal der erfindungsgemäßen Ausführungsform erwähnt und dient der Abgrenzung zu anderen Technologien. Nach dem heutigen, technischen Kenntnisstand ist es nicht möglich, eine amorphe Schicht innerhalb eines Substrats herzustellen, ohne eine Veränderung des (kristallinen) Gefüges im Transferweg der Ionen zu erzeugen. Durch Untersuchung des Gefüges vor bzw. nach der amorphen (Rest)Schicht ist eine eindeutige Identifizierung des erfindungsgemäßen Prozesses denkbar. Sind die Gefüge vor bzw. nach der amorphen Restschicht eindeutig nicht durch Ionenbeschuss verändert worden, musste die Erzeugung der vergrabenen amorphen Schicht durch den erfindungsgemäßen Bondprozess erfolgt sein.

Die Kraftbeaufschlagung führt insbesondere zu einer Annäherung der sich in der amorphen Phase vorliegenden, an den Oberflächen 1o, 1o' angeordneten Atome. Durch die vergleichsweise schon kleinen (insbesondere durch die Amorphisierung reduzierten) Dimensionen der Kavitäten 3 ist eine Verformung der Maxima 2e durch eine reine Verschiebung der Atome, insbesondere unterstützt durch Diffusionsvorgänge, ausreichend, um die Kavitäten 3 praktisch vollständig zu schließen. Eine Plastifizierung des Gefüges erfolgt daher nicht durch aus der Plastizitätstheorie bekannte Plastifizierungsprozesse wie Versetzungsbewegung oder Zwillingsbildung, sondern zumindest überwiegend, vorzugsweise ausschließlich, durch Annäherung und/oder Verschiebung und/oder Diffusion hervorgerufene oder unterstützte Bewegung der einzelnen Atome.

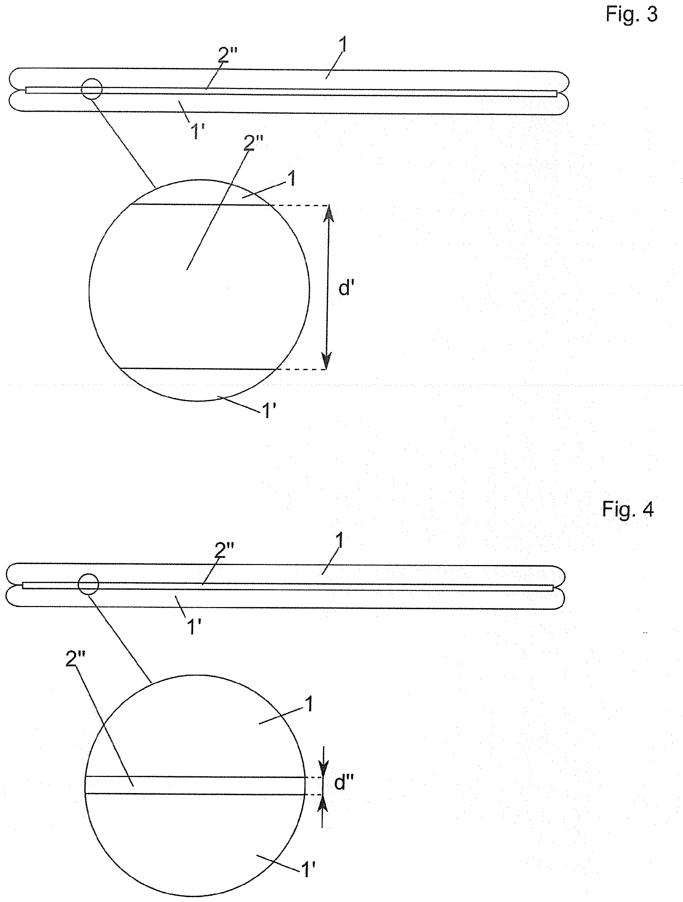

In einem weiteren erfindungsgemäßen Prozessschritt gemäß Figur 4 erfolgt eine, insbesondere zumindest überwiegend durch Rekristallisierung bewirkte, Umwandlung der amorphen Schicht 2". Die Umwandlung, insbesondere Rekristallisierung, führt zu einer kontinuierlichen Abnahme der Schichtdicke d' bis auf eine erfindungsgemäße Endschichtdicke d", die gemäß einer ganz bevorzugten erfindungsgemäßen Ausführungsformen gleich 0 (Null) ist. Das Verhältnis zwischen d"/d und/oder d"/d' ist kleiner oder gleich 1, vorzugsweise kleiner als 0.5, noch bevorzugter kleiner als 0.25, am bevorzugtesten kleiner als 0.1, am allerbevorzugtesten gleich 0. Daraus ergibt sich insbesondere ein vollständiger, nahezu defektfreier kristalliner Übergang zwischen den beiden Substraten 1, 1'. Dies kann sich schon während und/oder kurz nach dem Bonden, insbesondere noch in der Bondkammer ereignen. Dabei wird insbesondere die Heizvorrichtung eines Bonders beim Bonden zur Erwärmung des Substratstapels (Wärmebehandlung) verwendet.

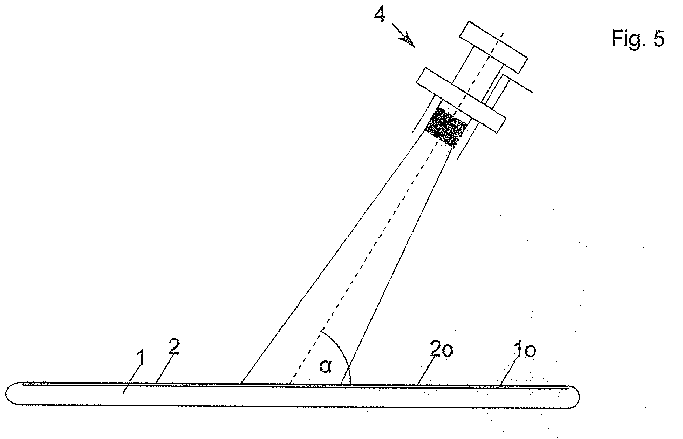

Figur 5 zeigt eine Ionenquelle 4, die Ionen eines Ionenstrahls 5 unter einem Einfallswinkel $\alpha$ zur Substratoberfläche 1o, auf die Substratoberfläche 2o beschleunigt.

## Bezugszeichenliste

| | |
|---|---|
| 1, 1' | Substrate |
| 1o, 1o' | Substratoberflächen |
| 1r, 1r' | Rückseiten |
| 2, 2', 2" | Amorphe Schichten |
| 2o, 2o' | Oberfläche |
| 2e | Maxima |
| 2m | Minima |
| 3 | Kavitäten |
| 4 | Ionenquelle |
| 5 | Ionenstrahl |
| d, d', d'' | Dicken |
| $\alpha$ | Einfallswinkel |

## Patentansprüche

1. Vorrichtung zur Oberflächenbehandlung einer Substratoberfläche (1o) eines Substrats (1) mit:

    - einer Prozesskammer zur Aufnahme des Substrats (1) und
    - Mitteln zur Amorphisierung der Substratoberfläche (1o) unter Bildung einer amorphen Schicht (2, 2', 2") an der Substratoberfläche (1o) mit einer Dicke d > 0nm der amorphen Schicht (2, 2', 2").

2. Vorrichtung nach Anspruch 1, bei der die Amorphisierung bis zu einer Dicke d < 100nm der amorphen Schicht (2, 2', 2"), insbesondere d < 50nm, vorzugsweise d < 10nm, noch bevorzugter d < 5nm, noch bevorzugter d < 2nm erfolgt.

3. Vorrichtung nach einem der vorhergehenden Ansprüche, bei der die Amorphisierung derart durchgeführt wird, dass die mittlere Rauheit der Substratoberfläche (1o, 1o') abnimmt, insbesondere auf eine mittlere Rauheit kleiner als 10nm, vorzugsweise kleiner als 8nm, noch bevorzugter kleiner als 6nm, noch bevorzugter kleiner als 4nm, noch bevorzugter kleiner als 2nm.

4. Vorrichtung nach einem der vorhergehenden Ansprüche, bei der die Amorphisierung durch Teilchenkollision mit der Substratoberfläche (1o, 1o') mit Teilchen, insbesondere Ionen, bewirkt wird, insbesondere durch Beschleunigung der Teilchen, wobei bevorzugt der Einfallswinkel zwischen Substratoberfläche (10, 10') und Ionenstrahl frei wähl- und einstellbar ist, wobei der Einfallswinkel bevorzugt zwischen 75° und 90° liegt, weiter bevorzugt bei 90° liegt.

5. Vorrichtung nach Anspruch 4, bei der eine kinetische Energie der Teilchen zwischen 1 eV und 1000 keV, vorzugsweise zwischen 1 eV und 100 keV, noch bevorzugter zwischen 1 eV und 10 keV, noch bevorzugter zwischen 1 eV und 200 eV eingestellt wird.

6. Vorrichtung nach Anspruch 4 oder 5, bei der Stromdichte der Teilchen zwischen 0.1 mA/cm$^2$ und 1000 mA/cm$^2$, vorzugsweise zwischen 1.0 mA/cm$^2$ und 500 mA/cm$^2$, noch bevorzugter zwischen 50 mA/cm$^2$ und 100 mA/cm$^2$, am bevorzugtesten zwischen 70 mA/cm$^2$ und 80 mA/cm$^2$, am allerbevorzugtesten 75 mA/cm$^2$, eingestellt wird.

7. Vorrichtung nach einem der vorhergehenden Ansprüche, bei der die Prozesskammer vor der Amorphisierung evakuiert wird, insbesondere auf einen Druck kleiner 1 bar, mit Vorzug kleiner 10$^{-3}$ bar, mit größerem Vorzug kleiner 10$^{-5}$ bar, mit noch größerem Vorzug kleiner 10$^{-7}$ bar, noch bevorzugter kleiner 10$^{-8}$ bar.

8. Vorrichtung nach einem der vorhergehenden Ansprüche, aufweisend eine Bondkammer, wobei die Bondkammer vorzugsweise in einer Cluster-Anlage integral an die Prozesskammer angeschlossen ist, noch bevorzugter unter ständiger Aufrechterhaltung einer Evakuierung in der Prozesskammer und in der Bondkammer.

9. Vorrichtung nach einem der vorhergehenden Ansprüche, wobei nach der Amorphisierung eine Ausrichtung der Substrate zueinander erfolgt.

10. Vorrichtung nach Anspruch 9, wobei nach der Ausrichtung eine Kontaktierung erfolgt, wobei die Kontaktierung vorzugsweise im Zentrum begonnen und radial nach außen bis zur vollständigen Kontaktierung fortgeführt wird.

11. Vorrichtung nach Anspruch 10, wobei die Kontaktierung eine Vorfixierung bewirkt mit einer Bindungsfestigkeit zwi-schen 0.01 J/m$^2$ und 2.5 J/m$^2$, bevorzugt zwischen 0.1 J/m$^2$ und 2 J/m$^2$, noch bevorzugter zwischen 0.5 J/m$^2$ und 1.5 J/m$^2$, am bevorzugtesten zwischen 0.8 J/m$^2$ und 1.2 J/m$^2$

12. Vorrichtung nach einem der vorhergehenden Ansprüche, wobei Prozessparameter derart gewählt werden, dass eine vollständige Umwandlung der amorphen Schicht (2, 2', 2") in die kristalline Phase erfolgt.

13. Vorrichtung nach einem der vorhergehenden Ansprüche, wobei folgende Gase und/oder Gasgemische für die Amorphisierung ionisiert werden:

   • Atomare Gase, insbesondere

      ◦ Ar, He, Ne, Kr,

   • Molekulare Gase, insbesondere

      ◦ $H_2$, $N_2$, CO, $CO_2$,

   • Gasgemische, insbesondere

      • Formiergas FG ( Argon + Wasserstoff) und/oder

• Formiergas RRG (Wasserstoff + Argon) und/oder
• Formiergas NFG (Argon + Stickstoff) und/oder
• Wasserstoff.

**14.** Cluster-Anlage, aufweisend eine Vorrichtung nach einem der vorhergehenden Ansprüche.

Fig. 1

Fig. 2

Fig. 3

Fig. 4

Fig. 5

Europäisches
Patentamt

European
Patent Office

Office européen
des brevets

## EUROPÄISCHER RECHERCHENBERICHT

**Nummer der Anmeldung**

EP 17 16 4931

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 2 672 509 A1 (SUGA TADATOMO [JP]; BONDTECH CO LTD [JP]; TAIYO YUDEN KK [JP]; LAN TEC) 11. Dezember 2013 (2013-12-11) * Abbildungen 1,3 * | 1-14 | INV. H01L21/20 C23C14/48 H01L21/762 |
| A | US 2003/141502 A1 (TONG QIN-YI [US]) 31. Juli 2003 (2003-07-31) * Absatz [0052] - Absatz [0054]; Abbildungen 2a-2e,7-8c,15a-16e * * Absätze [0056] - [0075] * | 2-4,10, 11 | |
| A | US 2007/072391 A1 (POCAS STEPHANE [FR] ET AL) 29. März 2007 (2007-03-29) * Absätze [0057], [0008], [0064], [0065]; Ansprüche 27,31-33,55-77; Abbildungen 2A-3; Beispiele 2,7,8 * | 1 | |
| A | US 2007/128825 A1 (SUGA TADATOMO [JP] ET AL) 7. Juni 2007 (2007-06-07) * Zusammenfassung; Abbildungen 1,2 * | 1-13 | |

**RECHERCHIERTE SACHGEBIETE (IPC)**

H01L

Der vorliegende Recherchenbericht wurde für alle Patentansprüche erstellt

| Recherchenort | Abschlußdatum der Recherche | Prüfer |
|---|---|---|
| Den Haag | 25. Juli 2017 | Hedouin, Mathias |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
........................................................................................
& : Mitglied der gleichen Patentfamilie, übereinstimmendes
   Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 17 16 4931

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-07-2017

| Im Recherchenbericht angeführtes Patentdokument | Datum der Veröffentlichung | Mitglied(er) der Patentfamilie | Datum der Veröffentlichung |
|---|---|---|---|
| EP 2672509 A1 | 11-12-2013 | CN 103493177 A<br>EP 2672509 A1<br>JP WO2012105473 A1<br>KR 20140048084 A<br>US 2014048805 A1<br>WO 2012105473 A1 | 01-01-2014<br>11-12-2013<br>03-07-2014<br>23-04-2014<br>20-02-2014<br>09-08-2012 |
| US 2003141502 A1 | 31-07-2003 | AU 8060201 A<br>TW 556251 B<br>US 6563133 B1<br>US 2003141502 A1<br>WO 0213247 A1 | 18-02-2002<br>01-10-2003<br>13-05-2003<br>31-07-2003<br>14-02-2002 |
| US 2007072391 A1 | 29-03-2007 | AT 441205 T<br>EP 1697975 A1<br>FR 2864336 A1<br>JP 4884979 B2<br>JP 2007535133 A<br>US 2007072391 A1<br>WO 2005064657 A1 | 15-09-2009<br>06-09-2006<br>24-06-2005<br>29-02-2012<br>29-11-2007<br>29-03-2007<br>14-07-2005 |
| US 2007128825 A1 | 07-06-2007 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5441776 A
- US 7462552 B2
- US 7550366 B2
- EP 2013064239 W
- EP 2011064874 W
- EP 2014056545 W